(19) Europäisches Patentamt / European Patent Office / Office européen des brevets

(11) **EP 4 560 398 A1**

(12) **EUROPEAN PATENT APPLICATION**
published in accordance with Art. 153(4) EPC

(43) Date of publication:
**28.05.2025 Bulletin 2025/22**

(21) Application number: **23860128.0**

(22) Date of filing: **22.08.2023**

(51) International Patent Classification (IPC):
*G03F 1/62* (2012.01)     *G03F 1/82* (2012.01)
*G03F 7/20* (2006.01)

(52) Cooperative Patent Classification (CPC):
**G03F 1/62; G03F 1/82; G03F 7/20**

(86) International application number:
**PCT/JP2023/030137**

(87) International publication number:
**WO 2024/048365 (07.03.2024 Gazette 2024/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **02.09.2022   JP 2022140279
23.03.2023   JP 2023047154**

(71) Applicant: **Mitsui Chemicals, Inc.**
**Tokyo 104-0028 (JP)**

(72) Inventors:
• **ITO, Ken**
  **Kuga-gun, Yamaguchi 740-0061 (JP)**
• **TANEICHI, Daiki**
  **Kuga-gun, Yamaguchi 740-0061 (JP)**
• **KOHMURA, Kazuo**
  **Kuga-gun, Yamaguchi 740-0061 (JP)**
• **OKUBO, Atsushi**
  **Sodegaura-shi, Chiba 299-0265 (JP)**

(74) Representative: **Hoffmann Eitle**
**Patent- und Rechtsanwälte PartmbB**
**Arabellastraße 30**
**81925 München (DE)**

(54) **FOREIGN MATTER REMOVAL DEVICE, PELLICLE PRODUCTION DEVICE, PELLICLE PRODUCTION METHOD, AND PELLICLE**

(57)     The present disclosure provides a foreign matter removing device that includes: a vacuum ultraviolet light generating section generating vacuum ultraviolet light; an irradiation container for irradiating the vacuum ultraviolet light onto a pellicle film; and a gas supplying section supplying inert gas to the irradiation container. The irradiation container has an irradiation chamber at which are provided a gas supply port for supplying the inert gas and a gas discharge port for discharging the inert gas. The gas supplying section is connected to the gas supply port.

FIG.2

EP 4 560 398 A1

## Description

Technical Field

The present disclosure relates to a foreign matter removing device, a pellicle producing device, a pellicle producing method, and a pellicle.

Background Art

Miniaturization of semiconductor integrated circuits is being advanced by photolithography. A transparent substrate (hereinafter called "photomask"), on one surface of which a pattern is formed, is used in photolithography. A pellicle is affixed to the photomask in order to prevent foreign matter such as dust from adhering to the surface of the photomask.

On the other hand, Patent Document 1 discloses a device/method of generating a pressure pulse in gas by using a pressure pulse laser, and removing foreign matter. Patent Document 2 discloses a device/method of removing foreign matter from a film by generating an electrical field near the film and vibrating the film.

Patent Document 1: International Publication No. 2021/073799
Patent Document 2: International Publication No. 2020/109152

SUMMARY OF INVENTION

Technical Problem

There is the concern that many pieces of foreign matter will adhere to the pellicle film in the pellicle production process and the like. Foreign matter on a pellicle film increases the absorption of radiation during exposure of the substrate, and as a result, there is the possibility of giving rise to local hot spots at the pellicle film, which may lead to damage to the pellicle film. Therefore, removal of foreign matter adhering to a pellicle film is desired.

The present disclosure was made in view of the above-described circumstances.

A topic to be addressed by embodiments of the present disclosure is the provision of a foreign matter removing device, a pellicle producing device and a pellicle producing method that can prevent the occurrence of damage to a pellicle film and remove foreign matter adhering to the pellicle film.

A topic to be addressed by another embodiment of the present disclosure is the provision of a pellicle that can suppress a decrease in the yield rate of production of semiconductors.

Solution to Problem

Means for addressing the above topics include the following embodying aspects.

<1> A foreign matter removing device including:

a vacuum ultraviolet light generating section generating vacuum ultraviolet light;
an irradiation container for irradiating the vacuum ultraviolet light onto a pellicle film; and
a gas supplying section supplying inert gas to the irradiation container,
wherein the irradiation container has an irradiation chamber at which are provided a gas supply port for supplying the inert gas and a gas discharge port for discharging the inert gas, and
wherein the gas supplying section is connected to the gas supply port.

<2> The foreign matter removing device of above <1>, further including, at a border between the irradiation chamber and the vacuum ultraviolet light generating section, a transmitting portion that transmits the vacuum ultraviolet light.
<3> The foreign matter removing device of above <1> or <2>, further including a stage that is disposed within the irradiation chamber and is for placement of the pellicle film.
<4> The foreign matter removing device of any one of above <1> through <3>, wherein the inert gas includes nitrogen gas.
<5> The foreign matter removing device of any one of above <1> through <4>, wherein a cumulative amount of the vacuum ultraviolet light is from 0.1 J/cm$^2$ to 100 J/cm$^2$.

<6> The foreign matter removing device of any one of above <1> through <5>, wherein illuminance of the vacuum ultraviolet light is from 5 mW/cm$^2$ to 100 mW/cm$^2$.

<7> The foreign matter removing device of above <3>, further including, at a border between the irradiation chamber and the vacuum ultraviolet light generating section, a transmitting portion that transmits the vacuum ultraviolet light, wherein the irradiation container further has a distance adjusting section that adjusts a distance between the transmitting portion and the stage.

<8> The foreign matter removing device of any one of above <1> through <7>, wherein the gas discharge port is disposed at a position that is lower than a height positioned at a center of the irradiation chamber, in a height direction of the irradiation chamber.

<9> The foreign matter removing device of above <8>, wherein the gas supply port is disposed at a position that is higher than the height positioned at the center of the irradiation chamber, in the height direction of the irradiation chamber.

<10> The foreign matter removing device of any one of above <1> through <9>, wherein:

the irradiation chamber has two wall portions that face one another,
the gas supply port is disposed at one of the two wall portions that face one another, and
the gas discharge port is disposed at another of the two wall portions that face one another.

<11> A pellicle producing device including the foreign matter removing device of any one of above <1> through <10>.

<12> A pellicle film producing method including:

supplying inert gas to an irradiation chamber; and
irradiating vacuum ultraviolet light onto a pellicle film in an inert gas atmosphere within the irradiation chamber, wherein a concentration of oxygen gas in the inert gas atmosphere within the irradiation chamber is 5 vol% or less.

<13> The pellicle film producing method of above <12>, wherein the concentration of the oxygen gas within the irradiation chamber is 3 vol% or less.

<14> The pellicle film producing method of above <12> or <13>, wherein the inert gas includes nitrogen gas.

<15> The pellicle film producing method of any one of above <12> through <14>, wherein a flow rate of the inert gas is from 10 L/minute to 1000 L/minute.

<16> The pellicle film producing method of any one of above <12> through <15>, wherein a cumulative amount of the vacuum ultraviolet light is from 0.1 J/cm$^2$ to 100.0 J/cm$^2$.

<17> The pellicle film producing method of any one of above <12> through <16>, wherein illuminance of the vacuum ultraviolet light is from 5 mW/cm$^2$ to 100 mW/cm$^2$.

<18> The pellicle film producing method of any one of above <12> through <17>, wherein an irradiation time of the vacuum ultraviolet light is from 1 second to 30 minutes.

<19> The pellicle film producing method of any one of above <12> through <18>, wherein:

the irradiation chamber has, at a border of the irradiation chamber, a transmitting portion that transmits the vacuum ultraviolet light, and
an irradiation distance between the transmitting portion and the pellicle film is from 0.3 mm to 2.0 mm.

<20> The pellicle producing method of any one of above <12> through <19>, wherein a film thickness of the pellicle film is 100 nm or less.

<21> A pellicle including:

a pellicle frame; and
a pellicle film supported at the pellicle frame,
wherein:

the pellicle film has a film thickness of 100 nm or less,
the pellicle film contains foreign matter of a size of from 1 $\mu$m to 5 $\mu$m, and
a number of pieces of the foreign matter is 35 or fewer.

Advantageous Effects of Invention

In accordance with embodiments of the present disclosure, there are provided a foreign matter removing device, a pellicle producing device and a pellicle producing method that can prevent the occurrence of damage to a pellicle film and remove foreign matter adhering to the pellicle film.

In accordance with another embodiment of the present disclosure, there is provided a pellicle that can suppress a decrease in the yield rate of production of semiconductors.

BRIEF DESCRIPTION OF DRAWINGS

Fig. 1 is a cross-sectional view of a foreign matter removing device relating to a first embodiment of the present disclosure.

Fig. 2 is a cross-sectional view of a foreign matter removing device relating to a second embodiment of the present disclosure.

DESCRIPTION OF EMBODIMENTS

In the present disclosure, numerical value ranges expressed by using " to " mean ranges in which the numerical values listed before and after the " to " are included as the minimum value and maximum value, respectively.

In numerical value ranges that are expressed in a stepwise manner in the present disclosure, the maximum value or the minimum value listed in a given numerical value range may be substituted by the maximum value or the minimum value of another numerical value range that is expressed in a stepwise manner. In the numerical value ranges mentioned in the present disclosure, the maximum value or the minimum value listed in a given numerical value range may be substituted by a value used in the Examples.

In the present disclosure, combinations of two or more preferable aspects are more preferable aspects.

In the present disclosure, in a case in which there are plural types of materials that correspond to a component, the amount of that component means the total amount of the plural types of materials, unless otherwise stated.

In the present disclosure, the word "step" does not mean only an independent step and includes steps that, even in a case in which that step cannot be clearly distinguished from another step, achieve the intended object of that step.

(1) Foreign Matter Removing Device

The foreign matter removing device of the present disclosure includes a vacuum ultraviolet (hereinafter, "VUV") light generating section generating VUV light; an irradiation container for irradiating the VUV light onto a pellicle film; and a gas supplying section supplying inert gas to the irradiation container. The irradiation container has an irradiation chamber at which are provided a gas supply port for supplying the inert gas and a gas discharge port for discharging the inert gas. The gas supplying section is connected to the gas supply port.

In the present disclosure, "VUV light" means light having a wavelength of from 100 nm to 200 nm, and may be light having a wavelength of from 160 nm to 180 nm.

In the present disclosure, "inert gas" means a gas of molecules that, by absorbing VUV light gas, are radicalized or ionized, and make it easy to remove foreign matter adhering to a pellicle film.

Because the foreign matter removing device of the present disclosure has the above-described structure, it can prevent the occurrence of damage to a pellicle film and remove foreign matter adhering to the pellicle film.

This effect is surmised to be due to the following reasons, but is not limited thereto.

In the present disclosure, when the gas supplying section supplies inert gas into the irradiation chamber, the gas (e.g., atmospheric air) within the irradiation chamber is discharged to the exterior of the irradiation chamber via the gas discharge port. Due thereto, the majority of the gas within the irradiation chamber is replaced by the inert gas, and an oxygen concentration of the interior of the irradiation chamber of 5 vol% or less can be obtained. Note that the oxygen concentration of atmospheric air is around 21 vol%. When the VUV light generating section generates VUV light, the VUV light is irradiated via a transmitting portion toward a pellicle film placed on a stage. Because the wavelength of VUV light is short, it is easily absorbed by the gas molecules (e.g., oxygen). When the oxygen molecules absorb VUV light, it is easy for active oxygen species (e.g., ozone, oxygen radicals) to be generated.

When VUV light is generated in an inert atmosphere in which the oxygen concentration of the irradiation chamber interior is 5 vol% or less, the amount of the active oxygen species (e.g., ozone, oxygen radicals) that is generated is lower. Due thereto, film reduction of the pellicle film due to the active oxygen species is suppressed.

On the other hand, a photoelectric effect occurs due to the irradiation of VUV light onto foreign matter and the pellicle film, and the foreign matter and the pellicle film are respectively charged positive. Due to the repulsion between the positively-charged foreign matter and the positively-charged pellicle film, the positively-charged foreign matter separates from the pellicle film. The circulating gas moves the separated foreign matter. As a result, the foreign matter is discharged from the gas discharge port to the exterior of the irradiation chamber. In particular, the mass of foreign matter that is small is small. Therefore, it is thought that it is easy for small foreign matter to separate from the pellicle film and to be discharged from the gas discharge port to the exterior of the irradiation chamber.

As a result, it is supposed that the foreign matter removing device of the present disclosure can prevent the occurrence of damage to the pellicle film and remove foreign matter adhering to the pellicle film.

At a pellicle that is used in exposure utilizing EUV (extreme ultraviolet) light as the light source for the exposure (hereinafter called "pellicle for EUV light"), the EUV light transmittance is made to be high. Therefore, in pellicles for EUV light, the thickness of the pellicle film is extremely thin (e.g., around several nm to 200 nm). Therefore, the foreign matter removing device of the present disclosure is suitably used in order to remove foreign matter adhering to the pellicle film of a pellicle for EUV.

The shape, size and the like of the foreign matter removing device are not particularly limited, and it suffices for them to be adjusted appropriately in accordance with the numbers of, the sizes of and the like of the VUV light generating section, the irradiation container, and the gas supplying section. The foreign matter removing device may be a large-size device for mass-producing pellicles, or may be a laboratory-level, compact device.

(1.1) Irradiation Container

The foreign matter removing device of the present disclosure has an irradiation container.

The number of irradiation containers is not particularly limited, and it suffices for there to be at least one, and it suffices for the number thereof to be adjusted appropriately in accordance with the scale of the foreign matter removing device. The size, the shape and the like of the irradiation container are not particularly limited, and it suffices for them to be selected appropriately in accordance with the scale and the like of the foreign matter removing device.

(1.1.1) Irradiation Chamber

The irradiation container has an irradiation chamber. The irradiation of VUV light onto a pellicle film is carried out at the interior of the irradiation chamber.

The number of irradiation chambers is not particularly limited, and it suffices for there to be at least one, and it suffices for the number thereof to be adjusted appropriately in accordance with the scale and the like of the foreign matter removing device. The size, the shape and the like of the irradiation chamber are not particularly limited, and it suffices for them to be selected appropriately in accordance with the scale and the like of the foreign matter removing device.

(1.1.1.1) Gas Supply Port and Gas Discharge Port

The gas supply port and the gas discharge port are provided at the irradiation chamber. The gas supply port is used in order to supply inert gas to the interior of the irradiation chamber. The gas discharge port is used in order to discharge inert gas from the interior of the irradiation chamber. Due thereto, the oxygen concentration within the irradiation chamber can be adjusted so as to be in a desired range, and foreign matter that has adhered to the pellicle film can be discharged to the exterior of the irradiation chamber, and the number of pieces of foreign matter on the pellicle film can be reduced. Moreover, a rise in the pressure of the irradiation chamber interior due to the supply of the inert gas is suppressed. As a result, the durability of the irradiation chamber improves.

The gas supply port is connected to the gas supplying section. Details of the gas supplying section are described later. A known gas recovery device may be connected or may not be connected to the gas discharge port. If a gas recovery device is not connected to the gas discharge port, the gas discharge port may be open to the atmosphere.

The respective numbers of the gas supply ports and the gas discharge ports are not particularly limited, and it suffices for there to be at least one, and it suffices to adjust the numbers thereof appropriately in accordance with the size and the like of the irradiation chamber.

The respective placed positions of the gas supply port and the gas discharge port are not particularly limited, and it suffices for the positions to be adjusted appropriately in accordance with the size and the like of the irradiation chamber.

It is preferable that the gas discharge port be disposed at a position that, in the height direction of the irradiation chamber (i.e., the gravitational direction), is lower than a height positioned at the center of the irradiation chamber (i.e., the central portion, in the gravitational direction, of the irradiation chamber). Due thereto, it is easy to discharge the removed foreign matter to the exterior of the irradiation container. As a result, at the time of handling the pellicle film after processing, the occurrence of re-contamination by foreign matter that accumulates within the irradiation container can be suppressed.

If the gas discharge port is disposed at a position that is lower than a height positioned at the center of the irradiation chamber in the height direction of the irradiation chamber, it is preferable that the gas supply port is disposed at a position that, in the height direction of the irradiation chamber (i.e., the gravitational direction), is higher than a height positioned at the center of the irradiation chamber (i.e., the central portion, in the gravitational direction, of the irradiation chamber). Due thereto, it is easy for the gas that is supplied from the gas supply port to disperse uniformly within the irradiation container. As a result, it is easy for the foreign matter removing device of the present disclosure to manifest the intended effects (suppression of film breakage and removal of foreign matter).

It is preferable that the irradiation chamber have two wall portions facing one another, and that the gas supply port is disposed at one of the two, facing wall portions, and the gas discharge port is disposed at the other of the two, facing wall portions. Due thereto, the foreign matter removing device can more efficiently adjust the oxygen concentration within the irradiation chamber, and can more efficiently discharge the foreign matter, which has been separated from the pellicle film, to the exterior of the irradiation chamber. The height of the gas discharge port is preferably disposed at a place that is higher than the middle of the height of the irradiation chamber, and is more preferably disposed at the upper portion of the irradiation chamber. Due thereto, it is easy to suppress adhesion of foreign matter to the pellicle due to foreign matter, which has accumulated on the floor of the irradiation chamber, being flung-up. In order to facilitate the discharging of foreign matter, which has accumulated on the floor of the irradiation chamber, to the exterior of the irradiation chamber, it is preferable that the height of the gas discharge port is disposed at a place that is lower than the middle of the height of the irradiation chamber. In order to facilitate increasing the difficulty of flinging-up foreign matter that has accumulated on the floor of the irradiation chamber while also facilitating discharging of foreign matter, which has accumulated on the floor of the irradiation chamber, to the exterior of the irradiation chamber, it is preferable for gas discharge ports to be disposed at a place that is higher than the middle of the height of the irradiation chamber and at a place that is lower than the middle of the height of the irradiation chamber.

If one of the main surfaces of the pellicle film is disposed so as to face a stage that is described later, the gas supply port is preferably provided such that the advancing direction of the inert gas immediately after having been jetted-out from the gas supply port, and a direction orthogonal to the main surface (hereinafter also called "obverse") of the pellicle film that is at the side opposite the stage side thereof, are orthogonal to one another. Due thereto, it is difficult for excessive force to be imparted to the obverse of the pellicle film by the inert gas that is supplied from the gas supply port to the obverse of the pellicle film. As a result, the occurrence of film breakage of the pellicle film can be suppressed.

The angle of the direction orthogonal to the obverse of the pellicle film is not limited provided that application of excessive force to the obverse of the pellicle film can be suppressed. The angle of the direction orthogonal to the obverse of the pellicle film may be, for example, within a range of 85° to 95° with respect to the advancing direction of the inert gas immediately after having been jetted-out from the gas supply port. For similar reasons, it is preferable that the gas discharge port be provided such that the advancing direction of the inert gas immediately before entering into the gas discharge port, and the direction orthogonal to the obverse of the pellicle film, are orthogonal.

(1.1.1.2) Transmitting Portion

It is preferable that the foreign matter removing device of the present disclosure further have, at the border between the irradiation chamber and the vacuum ultraviolet light generating section, a transmitting portion through which the vacuum ultraviolet light is transmitted.

The transmitting portion may be at the irradiation chamber side, or may be in the irradiation chamber. In other words, the transmitting portion may be a part of a wall portion structuring the irradiation chamber, or may be a member separate from the wall portions structuring the irradiation chamber, e.g., a portion of the irradiation container. The shape of the transmitting portion is not particularly limited and may be flat-plate-shaped. The size and the thickness and the like of the transmitting portion are not particularly limited, and it suffices for them to be selected appropriately in accordance with the size and the number and the like of the pellicle films disposed in the irradiation chamber. It suffices for the material of the transmitting portion to be a material that transmits VUV light, and examples are quartz, magnesium fluoride ($MgF_2$), calcium fluoride ($CaF_2$), and lithium fluoride (LiF).

(1.1.1.3) Other Wall Portions

In addition to the transmitting portion, the irradiation chamber may have plural other wall portions. The transmitting portion and the plural other wall portions structure the internal space for irradiating VUV light onto the pellicle film. The volume, structure and the like of the internal space are not particularly limited, and it suffices for them to be adjusted appropriately in accordance with the size, the number and the like of the pellicle films disposed in the irradiation chamber. It suffices for the materials of the other wall portions to be materials that are difficult to be corroded by VUV light, and examples thereof are metals and ceramics. Examples of the metals are aluminum, iron, copper, nickel, gold, silver, platinum, cobalt, zinc, lead, tin, titanium, chromium, magnesium, manganese and alloys thereof (stainless steel, brass, phosphor bronze and the like). Thereamong, from standpoints such as excellent durability, it is preferable that the materials of the other wall portions contain aluminum, and it is preferable that the materials are aluminum.

The irradiation chamber may have a gas densitometer. The gas densitometer measures the concentration of the inert gas and the concentration of the oxygen gas within the irradiation chamber.

(1.1.2) Stage

The foreign matter removing device of the present disclosure preferably further has a stage that is disposed within the irradiation chamber and is for placement of the pellicle film. The pellicle film is placed on the stage. A pellicle having a pellicle film may be placed on the stage. In a case in which a pellicle film is placed on the stage, a carrier for a pellicle film, to which the pellicle film is attached, may be placed on the stage. The carrier for a pellicle film is, for example, a jig that carries a pellicle film. In a case in which a pellicle is placed on the stage, a carrier for a pellicle, to which the pellicle is attached, may be placed on the stage. The carrier for a pellicle is, for example, a jig that carries a pellicle. Details of the pellicle are described later.

The number of stages is not particularly limited, and it suffices for there to be at least one, and the number may be adjusted appropriately in accordance with the scale of the foreign matter removing device. The number of stages, with respect to one irradiation chamber, may be one or may be two or more. The stage may be a movable stage such as a belt conveyor.

The shape of the stage is not particularly limited provided that a pellicle film can be placed thereon, and is appropriately selected in accordance with the size, the number and the like of the pellicle films disposed in the irradiation chamber. The material of the stage is not particularly limited, and examples thereof are the same as those exemplified as materials of the other wall portions. Thereamong, from standpoints such as excellent durability, the material of the stage preferably contains aluminum, and preferably is aluminum.

(1.1.3) Distance Adjusting Section

In a case in which the foreign matter removing device of the present disclosure further has the transmitting portion, through which the vacuum ultraviolet light is transmitted, at the border between the irradiation chamber and the vacuum ultraviolet light generating section, it is preferable that the irradiation container further have a distance adjusting section. The distance adjusting section adjusts the distance between the transmitting portion and the stage. Due thereto, the distance between the transmitting portion and the pellicle film placed on the stage (hereinafter also simply called "irradiation distance") can be adjusted to a desired distance. As a result, the foreign matter removing device can efficiently remove foreign matter adhering to the pellicle film.

The irradiation distance is preferably from 0.3 mm to 2.0 mm. Due thereto, it is difficult for the VUV light to be absorbed by molecules existing between the transmitting portion and the distance adjusting section. Namely, it is easier for the pellicle film to be irradiated by the VUV light, and it is easier for removed foreign matter to be removed from on the top of the pellicle film. As a result, it is even easier to remove foreign matter adhering to the pellicle film.

The irradiation distance is more preferably 0.4 mm or more, and is even more preferably 0.5 mm or more. The irradiation distance is more preferably 1.8 mm or less, and even more preferably 1.6 mm or less, and particularly preferably 1.4 mm or less.

The mechanism that adjusts the distance between the transmitting portion and the stage is not particularly limited, and it suffices for the mechanism to be a known mechanism. A layering mechanism and the like are examples thereof. A layering mechanism adjusts the distance between the transmitting portion and the stage by layering thin, flat plates. The thickness of the flat plate is 1mm for example. The material of the distance adjusting section is not particularly limited, and examples thereof are the same as those exemplified as materials of the other wall portions. Thereamong, from standpoints such as excellent durability, the material of the distance adjusting section preferably contains aluminum, and preferably is aluminum.

In order to make it even easier to remove foreign matter adhering to the pellicle film, an insulating layer may be disposed on the stage of the present disclosure. Namely, an insulating layer may be provided between the stage and the pellicle that is placed on the stage. In order to remove foreign matter adhering to the pellicle film while preventing the occurrence of breakage of the pellicle film, types (materials having different volume resistivities) of the insulating layer may be selected, or the thickness of the insulating layer may be adjusted. Glass, resin and the like can be used as the insulating layer.

(1.2) VUV Light Generating Section

The foreign matter removing device of the present disclosure has the VUV light generating section. The VUV light generating section generates VUV light. In detail, the VUV light generating section irradiates VUV light through the transmitting portion onto the pellicle film placed on the stage.

The number of VUV light generating sections is not particularly limited, and it suffices for there to be at least one, and it suffices for the number thereof to be adjusted appropriately in accordance with the scale of the foreign matter removing device. The number of VUV light generating sections, with respect to one irradiation chamber, may be one or may be two or more. The size, the shape and the like of the VUV light generating section are not particularly limited, and it suffices for them to be selected appropriately in accordance with the scale and the like of the foreign matter removing device.

It suffices for the VUV light generating section to be a known light emitting device that generates VUV light.

The VUV light generating section may include a light source having a main emission wavelength of from 100 nm to 200 nm (hereinafter also simply called "light source"). The light source is selected appropriately in accordance with the type of the inert gas supplied into the irradiation chamber and the like, and examples thereof are a xenon (Xe) excimer lamp (main emission wavelength: 172 nm) and a low-pressure mercury lamp (main emission wavelength: 185 nm). Thereamong, it is preferable that the light source be an Xe excimer laser from standpoints such as ultraviolet light of 172 nm can be radiated at a single wavelength and the light emitting efficiency is excellent.

The cumulative amount of the VUV light is preferably from 0.1 $J/cm^2$ to 100 $J/cm^2$. Due thereto, foreign matter can be removed while the occurrence of film breakage of the pellicle film is suppressed. The cumulative amount of the VUV light is more preferably 0.5 $J/cm^2$ or more, and even more preferably 1.0 $J/cm^2$ or more, and particularly preferably 1.5 $J/cm^2$ or more. The cumulative amount of the VUV light is more preferably 70 $J/cm^2$ or less, and even more preferably 50 $J/cm^2$ or less, and particularly preferably 30 $J/cm^2$ or less, and still more preferably 10 $J/cm^2$ or less.

The illuminance of the VUV light is not particularly limited, and is preferably from 5 $mW/cm^2$ to 100 $mW/cm^2$. Due thereto, foreign matter can be removed while the occurrence of film breakage of the pellicle film is suppressed.

In order facilitate removal of foreign matter in a short time, the illuminance of the VUV light is more preferably 10 $mW/cm^2$ or more, and even more preferably 20 $mW/cm^2$ or more, and particularly preferably 30 $mW/cm^2$ or more. In order to facilitate suppression of film breakage of the pellicle film, the illuminance of the VUV light is more preferably 70 $mW/cm^2$ or less, and even more preferably 66 $mW/cm^2$ or less, and particularly preferably 60 $mW/cm^2$ or less. Due thereto, the illuminance of the VUV light is preferably 10 $mW/cm^2$ or more and 100 $mW/cm^2$, and more preferably 20 $mW/cm^2$ or more and 70 $mW/cm^2$ or less, and even more preferably 30 $mW/cm^2$ or more and 70 $mW/cm^2$ or less.

(1.3) Gas Supplying Section

The foreign matter removing device of the present disclosure has the gas supplying section. The gas supplying section supplies inert gas to the irradiation container. Specifically, the gas supplying section supplies inert gas through the gas supply port into the irradiation chamber.

The number of gas supplying sections is not particularly limited, and it suffices for there to be at least one, and it suffices for the number thereof to be adjusted appropriately in accordance with the scale of the foreign matter removing device. The number of gas supplying sections, with respect to one irradiation chamber, may be one or may be two or more. The size, the shape and the like of the gas supplying section are not particularly limited, and it suffices for them to be selected appropriately in accordance with the scale and the like of the foreign matter removing device.

Examples of the inert gas are nitrogen ($N_2$) gas, xenon (Xe) gas, and carbon dioxide ($CO_2$) gas. The inert gas is preferably at least one type selected from the group consisting of nitrogen ($N_2$) gas, xenon (Xe) gas, and carbon dioxide ($CO_2$) gas. Thereamong, from standpoints such as efficiently removing foreign matter adhering to the pellicle film, the inert gas more preferably includes nitrogen gas, and particularly preferably is nitrogen gas.

It suffices for the gas supplying section to be a known gas supplying device that supplies an inert gas. The gas supplying section may have a flow meter.

(1.4) First Embodiment

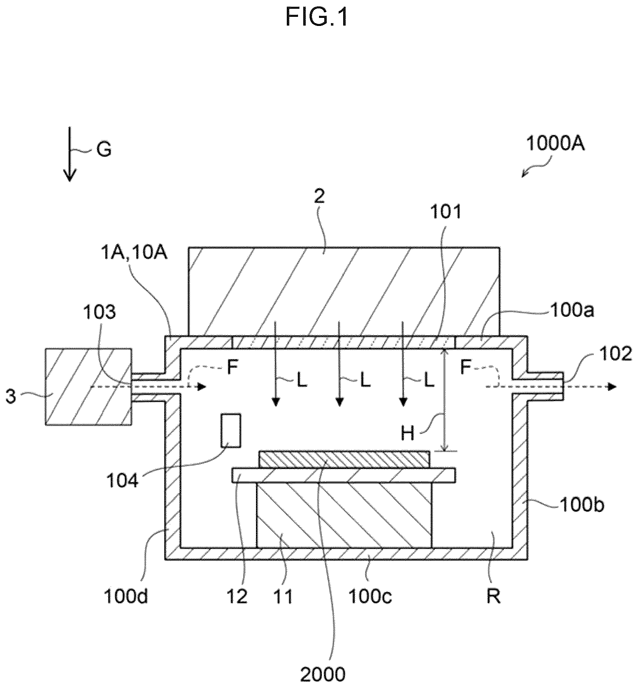

A foreign matter removing device relating to a first embodiment of the present disclosure is described hereinafter with reference to Fig. 1. In Fig. 1, reference letter "G" indicates the gravitational direction.

As illustrated in Fig. 1, foreign matter removing device 1000A has one irradiation container 1A, one VUV light generating section 2, and one gas supplying section 3. The VUV light generating section 2 and the gas supplying section 3 respectively are mounted to the irradiation container 1A.

(1.4.1) Irradiation Container

The irradiation container 1A has one irradiation chamber 10A. The irradiation chamber 10A has an internal space R therein. The internal space R is substantially parallelopiped, and, for example, is from 300 $cm^3$ to 600,000 $cm^3$, and may be from 5000 $cm^3$ to 200,000 $cm^3$.

(1.4.1.1) Irradiation Chamber

The irradiation chamber 10A further has an upper wall portion 100a, a right wall portion 100b, a lower wall portion 100c, a left wall portion 100d, a front wall portion (not illustrated), and a rear wall portion (not illustrated). The upper wall portion 100a and the lower wall portion 100c face one another. The right wall portion 100b and the left wall portion 100d face one another. The front wall portion and the rear wall portion face one another. The upper wall portion 100a, the right wall portion 100b, the lower wall portion 100c, the left wall portion 100d, the front wall portion and the rear wall portion structure the internal space R. The respective materials of the upper wall portion 100a, the right wall portion 100b, the lower wall portion 100c, the left wall portion 100d, the front wall portion and the rear wall portion are aluminum.

The upper wall portion 100a has a transmitting portion 101. The transmitting portion 101 structures a portion of the upper wall portion 100a. The transmitting portion 101 is a square, flat plate. The transmitting portion 101 is made of quartz. The VUV light generating section 2 is disposed at the surface of the transmitting portion 101 which surface is at the side opposite the internal space R.

The right wall portion 100b has a gas discharge port 102. The gas discharge port 102 communicates with the internal space R. The gas discharge port 102 opens to the atmosphere.

The left wall portion 100d has a gas supply port 103. The gas supply port 103 communicates with the internal space R. The gas supplying section 3 is connected to the gas supply port 103.

The irradiation chamber 10A has a gas densitometer 104. The gas densitometer 104 is disposed within the internal space R. The gas densitometer 104 is a known gas densitometer.

The irradiation container 1A further has one distance adjusting section 11 and one stage 12. The distance adjusting section 11 and the stage 12 are disposed within the internal space R. In detail, the distance adjusting section 11 is mounted on the lower wall portion 100c. The stage 12 is mounted on the distance adjusting section 11.

The mechanism of the distance adjusting section 11 is a layering mechanism. The material of the members structuring the distance adjusting section 11 is aluminum. In the present embodiment, the distance adjusting section is adjusted such that irradiation distance H is 1.0 mm.

The stage 12 is a square, flat plate. The material of the stage 12 is aluminum. A pellicle 2000 having a pellicle film is placed on the stage 12.

(1.4.2) VUV Light Generating Section

The VUV light generating section 2 is a known light emitting device that generates VUV light L. In the present embodiment, the known light emitting device includes a xenon (Xe) excimer lamp. The xenon (Xe) excimer lamp radiates ultraviolet light of 172 nm. The cumulative amount of the VUV light is from $0.1 \text{ J/cm}^2$ to $100 \text{ J/cm}^2$.

(1.4.3) Gas Supplying Section

The gas supplying section 3 is a known gas supplying device that supplies an inert gas F. In the present embodiment, the inert gas F is nitrogen ($N_2$) gas.

(1.4.4) Operation and Effects

As described with reference to Fig. 1, the foreign matter removing device 1000A has the irradiation container 1A, the VUV light generating section 2 and the gas supplying section 3 as illustrated in Fig. 1. The VUV light generating section 2 and the gas supplying section 3 respectively are mounted to the irradiation container 1A. The irradiation container 1A has the irradiation chamber 10A, at which the gas supply port 103 and the gas discharge port 102 are provided, and the stage 12. The irradiation chamber 10A has the transmitting portion 101. The gas supplying section 3 is connected to the gas supply port 103.

Due thereto, the foreign matter removing device 1000A can irradiate the VUV light L onto the pellicle film contained in the pellicle 2000, in an inert atmosphere in which the oxygen concentration within the irradiation chamber 10A is 5 vol% or less. As a result, the foreign matter removing device 1000A can prevent the occurrence of breakage of the pellicle film, and can remove foreign matter adhering to the pellicle film.

As described with reference to Fig. 1, the inert gas F contains nitrogen gas. Due thereto, the foreign matter removing device 1000A can efficiently remove foreign matter adhering to the pellicle film.

As described with reference to Fig. 1, the cumulative amount of the VUV light L is from $0.1 \text{ J/cm}^2$ to $100 \text{ J/cm}^2$. The foreign matter removing device 1000A can remove foreign matter while suppressing the occurrence of film breakage of the pellicle film.

As described with reference to Fig. 1, the irradiation container 1A further has the distance adjusting section 11. Due thereto, the irradiation distance H can be adjusted to a desired distance. As a result, the foreign matter removing device 1000A can efficiently remove foreign matter adhering to the pellicle film.

(1.5) Second Embodiment

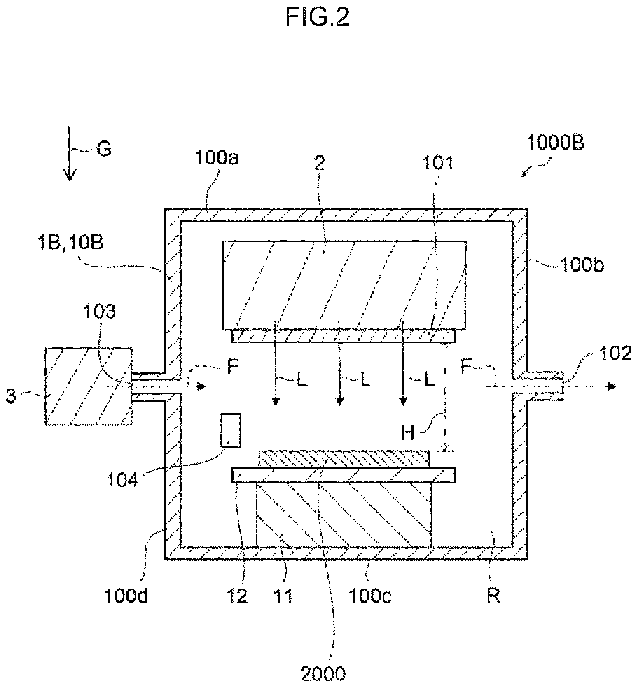

A foreign matter removing device relating to a second embodiment of the present disclosure is described hereinafter with reference to Fig. 2.

Foreign matter removing device 1000B is a structure similar to the foreign matter removing device 1000A, other than the fact that the transmitting portion 101 is not a portion of the upper wall portion 100a that structures the irradiation chamber 10A.

As illustrated in Fig. 2, the foreign matter removing device 1000B has one irradiation container 1B, the one VUV light generating section 2, and the one gas supplying section 3. The irradiation chamber 10A has the transmitting portion 101. The transmitting portion 101 is mounted to the rear wall portion (not illustrated).

Because the foreign matter removing device 1000B has the above-described structure, it exhibits operation and effects similar to those of the foreign matter removing device 1000A.

(2) Pellicle Producing Device

The pellicle producing device of the present disclosure includes the foreign matter removing device of the present disclosure.

Because the pellicle producing device of the present disclosure has the above-described structure, it can prevent the occurrence of breakage of the pellicle film and can remove foreign matter adhering to the pellicle film.

This effect is assumed to be due to reasons similar to the effects of the foreign matter removing device of the present disclosure, but is not limited to these.

The pellicle producing device of the present disclosure may include a known pellicle producing device. Examples of known pellicle producing devices are the pellicle producing device disclosed in International Publication No. 2015/182483 and the pellicle mounting device disclosed in International Publication No. 2015/182482.

(3) Pellicle

The pellicle of the present disclosure has a pellicle frame, and a pellicle film supported by the pellicle frame. The pellicle film has a film thickness of 100 nm or less. The pellicle film includes foreign matter of a size of from 1 $\mu$m to 5 $\mu$m. The number of pieces of foreign matter is 35 or fewer.

Because the pellicle of the present disclosure has the above-described structure, it can suppress a decrease in the yield rate of the mass production of semiconductors.

This effect is assumed to be due to the following reasons, but is not limited to these.

The number of pieces of foreign matter being 35 or fewer means that the number of pieces of foreign matter adhering to the pellicle film is extremely small. If the pellicle of the present disclosure is used, the number of pieces of foreign matter that move from the pellicle film to the photomask in the exposure process is small. Therefore, reduction in the yield of mass production of semiconductors is even less likely to occur. As a result, the pellicle of the present disclosure can suppress a decrease in the yield rate of the mass production of semiconductors.

The number of pieces of foreign matter is 35 or fewer. In particular, the closer the number of pieces of foreign matter is to 0, the more preferable it is, and it is most preferable that the number be 0.

The number of pieces of foreign matter is 35 or fewer, and is preferably 30 or fewer, and is more preferably 15 or fewer. The number of pieces of foreign matter may be 5. The number of pieces of foreign matter may be from 5 to 35. In particular, the closer the number of pieces of foreign matter is to 0 or fewer, the more preferable it is.

The method of measuring the number of pieces of foreign matter is similar to the method described in the Examples.

A method of implementing the pellicle film producing method of the present disclosure, which is described hereinafter, with respect to a pellicle film is an example of a method of keeping the number of pieces of foreign matter to 35 or fewer.

(3.1) Pellicle Frame

The pellicle of the present disclosure has the pellicle frame. The pellicle frame supports the pellicle film.

The pellicle frame may be a rectangular, tubular object formed from two long sides and two short sides. The pellicle frame has a through-hole. The through-hole means the space that the exposure light, which has been transmitted through the pellicle film, passes through in order to reach the photomask.

The pellicle frame may have vent holes. The vent holes communicate the internal space of the pellicle and the external space of the pellicle at the time when the pellicle frame is affixed to the photomask. The "internal space of the pellicle" means the space surrounded by the pellicle and the photomask. The "external space of the pellicle" means the space that is not surrounded by the pellicle and the photomask.

Examples of the material of the pellicle frame are aluminum, titanium, stainless steel, carbon-based materials, ceramic materials (e.g., silicon, glass), resins such as polyethylene, and the like. Thereamong, the material of the pellicle frame is preferably aluminum, titanium or silicon, and is more preferably silicon. The pellicle frame may be a layered structure of plural materials.

The shape of the pellicle frame corresponds to the shape of the photomask. Examples of the shape of the pellicle frame are a rectangular frame shape and a square frame shape.

(3.2) Pellicle Film

The pellicle of the present disclosure has the pellicle film. The pellicle film prevents foreign matter from adhering to the surface of the photomask, and, at the time of exposure, transmits the exposure light. Foreign matter includes dust. Examples of the exposure light are deep ultraviolet (DUV) light and EUV light.

The pellicle film covers the entire opening at one end surface side of the through-hole of the pellicle frame. The pellicle film may be supported directly at one end surface of the pellicle frame, or may be supported via a film adhesive layer. The film adhesive layer may be a known adhesive that has hardened.

The film thickness of the pellicle film is 100 nm or less, and is preferably from 1 nm to 100 nm, and is more preferably from 2 nm to 100 nm or less, and is even more preferably from 3 nm to 70 nm.

When viewed from the thickness direction thereof, the pellicle frame that is rectangular is structured by four sides.

The length, in the long-side direction, of one side is preferably 200 mm or less. The size and the like of the pellicle frame are standardized in accordance with the type of the exposure device. The length, in the long-side direction, of one side of the pellicle frame being 200 mm or less satisfies a size that is standardized for exposure using EUV light.

The length, in the short-side direction, of one side can be made to be from 5 mm to 180 mm for example, and is preferably from 80 mm to 170 mm, and is even more preferably from 100 mm to 160 mm.

The height of the pellicle frame (i.e., the length of the pellicle frame in the thickness direction) is not particularly limited, and is preferably 3.0 mm or less, and is more preferably 2.4 mm or less, and is even more preferably 2.375 mm or less. Due thereto, the pellicle frame satisfies a size that is standardized for EUV exposure. The height of the pellicle frame that is standardized for EUV exposure is, for example, 2.375 mm.

The mass of the pellicle frame is not particularly limited, and is preferably 20 g or less, and more preferably 15 g or less. Due thereto, the pellicle frame is suited to EUV exposure applications.

The pellicle film is not particularly limited, and examples thereof are a polysilicon (P-Si) film, a silicon nitride (SiN) film, a silicon carbide (SiC) film, a metal silicide film, a carbon nanotube film, and a graphene film. Thereamong, it is preferable that the pellicle film be a polysilicon (P-Si) film, a silicon nitride (SiN) film, a silicon carbide (SiC) film, a metal silicide film (e.g., a molybdenum silicide film) , a carbon nanotube film, or a graphene film. It is more preferable that the pellicle film be a polysilicon (P-Si) film, a silicon nitride (SiN) film, a silicon carbide (SiC) film, a metal silicide film or a carbon nanotube film, and it is more preferable that the pellicle film be a polysilicon (P-Si) film, a molybdenum silicide film or a carbon nanotube film. The carbon nanotube film may be single-walled carbon nanotubes, or may be multi-walled carbon nanotubes, or may contain single-walled carbon nanotubes and multi-walled carbon nanotubes.

(3.3) Adhesive Layer

The pellicle of the present disclosure may further have an adhesive layer, or may not have an adhesive layer. The adhesive layer makes it possible to adhere the pellicle of the present disclosure to a photomask.

The adhesive layer is a gel-like, viscoelastic body. The adhesive layer has viscosity and cohesive force. Viscosity means various properties of liquids that contact and wet the photomask that is the body to which the pellicle is adhered. Cohesive force means various properties of solids that resist peeling-off from the photomask.

As will be described later, the adhesive layer is formed by carrying out processes such as coating, heating, drying and curing of a coating composition.

The adhesive composition is not particularly limited, and may be a known adhesive. Examples of known adhesives are acrylic adhesives, silicone adhesives, styrene-butadiene adhesives, urethane adhesives and olefin adhesives.

(3.4) Liner

In a case in which the pellicle of the present disclosure further has an adhesive layer, the pellicle may further have, or may not have, a liner (peeling film).

The liner protects at least the surface of the adhesive layer that contacts the photomask. The liner can be peeled-off from the adhesive layer.

(4) Pellicle Film Producing Method

The pellicle film producing method of the present disclosure includes the supplying of inert gas into an irradiation chamber (hereinafter also called "gas supplying step"), and the irradiating of VUV light onto a pellicle film in an inert gas atmosphere within the irradiation chamber (hereinafter also called "irradiating step"). The irradiating of the VUV light and the supplying of the inert gas may be carried out simultaneously, but do not have to be carried out simultaneously. The inert gas atmosphere does not have to contain oxygen gas, or may contain oxygen gas. The concentration in a case in which oxygen gas is contained within the irradiation chamber is 5 vol% or less.

Because the pellicle film producing method of the present disclosure has the above-described structure, it can prevent the occurrence of breakage of the pellicle film and can remove foreign matter adhering to the pellicle film. Specifically, the pellicle of the present disclosure is obtained if the pellicle film producing method of the present disclosure is used with respect to a pellicle having a pellicle film to which foreign matter adheres.

This effect is assumed to be due to reasons similar to the effects of the foreign matter removing device of the present disclosure, but is not limited to these.

(4.1) Device

The pellicle film producing method may be implemented by using the foreign matter removing device of the present disclosure, or may be implemented without using the foreign matter removing device of the present disclosure. From standpoints such as efficiently implementing the pellicle film producing method, it is preferable that the pellicle film producing method be implemented by using the foreign matter removing device of the present disclosure.

(4.1.1) Irradiation Chamber

It suffices for the irradiation chamber to be a chamber having the functions of being able to irradiate VUV light onto the pellicle film and being able to keep the concentration of oxygen gas at 5 vol% or less. An example thereof is the irradiation chamber of the foreign matter removing device of the present disclosure.

The irradiation chamber has, at a border of the irradiation chamber, a transmitting portion through which VUV light is transmitted, and the distance between the transmitting portion and the pellicle film is preferably from 0.3 mm to 2.0 mm. If the irradiation distance is within the range of from 0.3 mm to 2.0 mm, it is easy for the VUV light to reach the pellicle film, and it is easy to remove the removed foreign matter from on top of the pellicle film. As a result, foreign matter adhering to the pellicle film can be removed.

The irradiation distance is more preferably 0.4 mm or more, and is even more preferably 0.5 mm or more. The irradiation distance is more preferably 1.8 mm or less, and even more preferably 1.6 mm or less, and particularly preferably 1.4 mm or less.

The method of adjusting the irradiation distance to the above-described range is not particularly limited, and an example thereof is a method using the distance adjusting section of the foreign matter removing device of the present disclosure.

(4.2) Gas Supplying Step

The pellicle film producing method includes the gas supplying step. **In** the gas supplying step, inert gas is supplied into the irradiation chamber. Due thereto, the majority of the gas within the irradiation chamber can be replaced with the inert gas. In other words, the interior of the irradiation chamber can become an inert gas atmosphere. As a result, the concentration of oxygen gas within the irradiation chamber may be zero (0 vol%), or, in a case in which oxygen gas is contained or a case in which oxygen gas flows-in from the exterior of the irradiation chamber or the like, the concentration of the oxygen gas may made to be in the range of 5 vol% or less.

The method of supplying inert gas into the irradiation chamber is not particularly limited, and an example thereof is a method using the gas supplying section of the foreign matter removing device of the present disclosure.

(4.2.1) Inert Gas

Inert gasses similar to those exemplified as the inert gas supplied by the gas supplying section of the foreign matter removing device of the present disclosure are examples of the inert gas. Thereamong, from standpoints such as efficiently removing foreign matter adhering to the pellicle film, the inert gas more preferably contains nitrogen gas, and particularly preferably is nitrogen gas.

The flow rate of the inert gas is not particularly limited, and is preferably 10 L/minute or more. If the flow rate of the inert gas is 10 L/minute or more, the removed foreign matter is discharged to the exterior of the irradiation container, and it can be made easy to remove foreign matter from the pellicle film, and the flow rate is preferably 50 L/minute or more. The upper limit may be, for example, 1000 L/minute or less, although there is no particular reason therefor. From these standpoints, the flow rate of the inert gas is preferably 10 L/minute or more and 1000 L/minute or less, and is more preferably from 30 L/minute to 1000 L/minute.

The flow rate of the inert gas is measured by a known flow meter.

(4.3) Irradiating Step

The pellicle film producing method includes the irradiating step. In the irradiating step, VUV light is irradiated onto the pellicle film in a specific inert gas atmosphere within the irradiation chamber. Due thereto, foreign matter adhering to the pellicle film can be separated from the pellicle film.

The method of irradiating VUV light onto the pellicle film is not particularly limited, and an example thereof is a method using the VUV light generating section of the foreign matter removing device of the present disclosure.

(4.3.1) Inert Gas Atmosphere

The inert gas atmosphere contains oxygen gas. The oxygen gas contained in the inert gas atmosphere may be oxygen gas that cannot be discharged from the interior of the irradiation chamber, even by the execution of the gas supplying step.

The concentration of the oxygen gas in the irradiation chamber is 5 vol% or less, and is preferably 3 vol% or less. If the concentration of the oxygen gas is 3 vol% or less, film reduction and breakage of the pellicle film can be suppressed more.

The concentration of the oxygen gas is not particularly limited, and it suffices for the concentration to be 0.000 vol% or more, and may be 0.001 vol% or more, and may be 0.005 vol% or more, and may be 0.10 vol% or more.

The concentration of the oxygen gas within the irradiation chamber is not particularly limited, and from the standpoint of removing foreign matter while suppressing the occurrence of film breakage of the pellicle film, is more preferably 2 vol% or less, and is even more preferably 1 vol% or less, and is still more preferably 0.8 vol% or less, and is yet even more preferably 0.5 vol% or less, and is particularly preferably 0.1 vol% or less.

From these standpoints, the concentration of the oxygen gas is preferably from 0.000 vol% to 5 vol%, and is more preferably from 0.000 vol% to 1 vol%, and is even more preferably from 0.001 vol% to 0.8 vol%, and is particularly preferably from 0.001 vol% to 0.5 vol%, and is still more preferably from 0.001 vol% to 0.1 vol%.

The concentration of the oxygen gas is measured by a known gas densitometer.

The inert gas atmosphere may contain an active gas in addition to oxygen. "Active gas" means a gas that reacts with the pellicle film and easily damages the pellicle film. The active gas contained in the inert gas atmosphere may be an active gas that cannot be discharged from the interior of the irradiation chamber even by the execution of the gas supplying step.

Examples of the active gas are water ($H_2O$), carbon monoxide (CO) gas and hydrogen ($H_2$) gas.

(4.3.2) Irradiation

The cumulative amount of the VUV light is not particularly limited, and is preferably from 0.1 J/cm$^2$ to 100.0 J/cm$^2$. Due thereto, foreign matter can be removed while the occurrence of film breakage of the pellicle film is suppressed. The cumulative amount of the VUV light is more preferably 0.5 J/cm$^2$ or more, and even more preferably 1.0 J/cm$^2$ or more, and particularly preferably 1.5 J/cm$^2$ or more. The cumulative amount of the VUV light is more preferably 70 J/cm$^2$ or less, and even more preferably 50 J/cm$^2$ or less, and particularly preferably 30 J/cm$^2$ or less, and still more preferably 10 J/cm$^2$ or less.

The illuminance of the VUV light is not particularly limited, and is preferably from 5 mW/cm$^2$ to 100 mW/cm$^2$. Due thereto, foreign matter can be removed while the occurrence of film breakage of the pellicle film is suppressed.

In order to facilitate removal of foreign matter in a short time, the illuminance of the VUV light is more preferably 10 mW/cm$^2$ or more, and even more preferably 20 mW/cm$^2$ or more, and particularly preferably 30 mW/cm$^2$ or more. In order to facilitate suppression of film breakage of the pellicle film, the illuminance of the VUV light is more preferably 70 mW/cm$^2$ or less, and even more preferably 66 mW/cm$^2$ or less, and particularly preferably 60 mW/cm$^2$ or less.

The VUV light irradiation time is not particularly limited, and is preferably 1 second to 30 minutes. If the VUV light irradiation time is 1 second or more, it can be made easy to remove foreign matter. If the VUV light irradiation time is 30 minutes or less, the occurrence of film breakage of the pellicle film can be suppressed more.

In the present disclosure, the gas supplying step and the irradiating step may be carried out simultaneously, but do not have to be carried out simultaneously. In a case in which the gas supplying step and the irradiating step are carried out simultaneously, it is easier to irradiate VUV light onto the pellicle film while maintaining a state in which the concentration of the oxygen gas is 5 vol% or less, than in a case in which the gas supplying step and the irradiating step are not carried out simultaneously. As a result, the occurrence of film breakage of the pellicle film is suppressed more.

For example, the operation of carrying out the starting of the supplying of an inert gas, the stoppage of the supplying of the inert gas, the starting of the irradiating of VUV light, and the stoppage of the irradiating of VUV light may be carried out at least one time within the irradiation chamber.

(4.4) Pellicle Film

In the pellicle producing method of the present disclosure, the film thickness of the pellicle film is preferably 100 nm or less.

Even if the film thickness of the pellicle film is 100 nm or less, the pellicle producing method of the present disclosure can prevent the occurrence of breakage of the pellicle film, and can remove foreign matter adhering to the pellicle film. From the same standpoint, film thicknesses of the pellicle film that are suited to the pellicle producing method of the present disclosure are preferably from 1 nm to 100 nm, and more preferably from 2 nm to 100 nm or less, and even more preferably from 3 nm to 70 nm.

(4.5) Preparatory Step

The pellicle producing method of the present disclosure may include a step of readying a pellicle (hereinafter also called "preparatory step"). In a case in which the pellicle producing method includes the preparatory step, a method of removing foreign matter of the pellicle film of the present disclosure is executed after the preparatory step is executed.

The method of readying the pellicle is not particularly limited, and examples are pellicle producing methods and methods of obtaining commercial products.

The pellicle producing method is not particularly limited, and it suffices for it to be a known producing method. Examples of known producing methods are the pellicle producing methods described in Japanese Patent Application Laid-Open (JP-A) No. 2021-157058, JP-A No. 2020-166063, JP-A No. 2020-160345, International Publication No. 2019/240166 and JP-A No. 2019-174628.

EXAMPLES

The present disclosure is described in further detail hereinafter by way of Examples, but the invention of the present disclosure is not limited to only these Examples.

[1] Example 1

Preparatory Step

[1.1.1] Foreign Matter Removing Device

The foreign matter removing device 1000A illustrated in Fig. 1 was readied.

Pellicle

A first pellicle was produced as follows as the pellicle 2000.

A polysilicon (p-Si) film of 100 nm or less was formed on a silicon substrate. Thereafter, the silicon substrate was etched from the surface at the side opposite the surface on which the polysilicon (p-Si) film was formed, and a self-standing film that was a polysilicon (p-Si) film was formed. "Self-standing film" means, of the polysilicon (p-Si) film, the region that is not supported by the silicon substrate. The first pellicle was thereby readied.

The first pellicle had a first pellicle frame obtained by etching the silicon substrate, and a first pellicle film formed from the polysilicon (p-Si) film. The first pellicle film was supported by the first pellicle frame. The size of the first pellicle was as follows.

    thickness of first pellicle film: 100 nm or less
    size (outer shape / outer diameter) of entire first pellicle frame: 151.3 mm × 139.7 mm × 2.4 mmt
    size (opening) of first pellicle frame: 143.6 mm × 111.1 mm

For foreign matter evaluation, foreign matter was scattered on the pellicle film, and the first pellicle was placed on the stage 12 within the irradiation chamber 10A of the irradiation container 1A. The irradiation distance H was adjusted to 1 mm.

Gas Supplying Step

The irradiation chamber 10A was sealed. The inert gas F (i.e., nitrogen ($N_2$) gas) was supplied from the gas supplying section 3 into the irradiation chamber 10A for two minutes and 30 seconds at a gas supplying rate of 50 L/minute. Thereafter, the supplying of the inert gas F into the irradiation chamber 10A was continued without stopping the supplying of the inert gas F. The nitrogen ($N_2$) gas within the irradiation chamber 10A was exhausted from the gas discharge port 102 to the exterior of the irradiation chamber 10A.

The oxygen concentration and the nitrogen concentration within the irradiation chamber 10A were measured by the gas densitometer 104. The oxygen concentration was 0.6 vol%. The nitrogen concentration was 98 vol% or more. Namely, it was understood that the interior of the irradiation chamber 10A was an inert gas atmosphere.

Irradiating Step

In the inert gas atmosphere within the irradiation chamber 10A, the VUV light L (wavelength: 172 nm, illuminance 33 mW/$cm^2$) was irradiated onto the first pellicle film for 30 seconds. An irradiated pellicle was thereby obtained.

[2] Comparative Example 1

An irradiated pellicle was obtained in the same way as in Example 1, except that a foreign matter removing device for comparison that is described hereinafter was readied instead of the foreign matter removing device 1000A, and the gas supplying step was not carried out. The foreign matter removing device for comparison had a structure similar to that of the foreign matter removing device 1000A illustrated in Fig. 1 except for not having the gas supplying section 3. At the time of carrying out the irradiating step, the oxygen concentration was 21 vol%. The nitrogen concentration was 79 vol.

[3] Example 2

An irradiated pellicle was obtained in the same way as in Example 1, except that a second pellicle described hereinafter was readied instead of the first pellicle, and the composition of the inert gas atmosphere was changed to the composition shown in Table 1.

Preparatory Step

The second pellicle was produced as follows.

An MoSi film of 100 nm or less was formed on a silicon substrate by CVD (chemical vapor deposition) while $N_2$ gas was made to flow. Thereafter, the silicon substrate was etched from the surface at the side opposite the surface on which the MoSi film was formed, and a self-standing film that was an MoSi film was formed. "Self-standing film" means, of the MoSi film, the region that is not supported by the silicon substrate. The second pellicle was thereby readied.

The second pellicle had a second pellicle frame obtained by etching the silicon substrate, and a second pellicle film formed from the MoSi film. The second pellicle film was supported by the second pellicle frame. The second pellicle film covered the opening of the second pellicle frame. The thickness of the second pellicle film was 100 nm or less. The size and the material of the second pellicle frame were the same as the size and the material of the first pellicle frame.

[4] Comparative Example 2

An irradiated pellicle was obtained in the same way as in Example 2, except that the above following foreign matter removing device for comparison was readied instead of the foreign matter removing device 1000A, and the gas supplying step was not carried out. At the time of carrying out the irradiating step, the oxygen concentration was 21 vol%. The nitrogen concentration was 79 vol.

[5] Example 3

A third pellicle of the same structure as the second pellicle was readied in the same way as in Example 2. An irradiated pellicle was obtained in the same way as in Example 2 except that the third pellicle was readied instead of the second pellicle, and the composition of the inert gas atmosphere was changed to the composition shown in Table 1, and the illuminance was made to be 66 mW/$cm^2$.

[6] Comparative Example 3

An irradiated pellicle was obtained in the same way as in Example 3, except that the above following foreign matter removing device for comparison was readied instead of the foreign matter removing device 1000A, and the gas supplying step was not carried out. At the time of carrying out the irradiating step, the oxygen concentration was 21 vol%. The nitrogen concentration was 79 vol.

[7] Example 4

An irradiated pellicle was obtained in the same way as in Example 1 except that the fourth pellicle described hereinafter was readied instead of the first pellicle.

Preparatory Step

The fourth pellicle was produced as follows.

Plural single-layer CNTs (manufactured by Meijo Nano Carbon Co., Ltd., product name: "EC1.5-P", tube diameter: from 1 nm to 3 nm, tube length: 100 nm or more), which were synthesized by eDIPS, were readied as plural CNTs.

70 mL of isopropyl alcohol and 30 mL of ethanol were added to 30 mg of the plural CNTs, and 30 mg of polyacrylic acid was further added thereto as an additive. This mixture was stirred for 18 hours at 40°C and 100 rpm (revolutions per minute) by using a magnetic stirrer. The obtained suspension was ultrasonically dispersed for a total of 30 minutes by using a probe-type homogenizer at an output of 40%, and a CNT dispersion was obtained.

An 8-inch-size silicon wafer (hereinafter called "silicon substrate") was readied. The CNT dispersion was spin coated at a rotational speed of 1500 rpm onto the silicon substrate. A coated film formed on the silicon substrate was thereby obtained.

The coated film was alkaline rinsed with tetramethyl ammonium hydroxide (hereinafter called "TMAH"), and the polyacrylic acid within the unrinsed CNT film was removed, and drying was carried out. A CNT film was thereby obtained.

Hereinafter, the silicon substrate and the CNT film formed on the silicon substrate are collectively called a "silicon substrate with the film".

The silicon substrate with the film was immersed in a water bath. In the water, the CNT film peeled-off from on top of the silicon substrate. The CNT film that had peeled-off from on top of the silicon substrate was left in the water, and the silicon substrate was taken-out of the water. At this time, the CNT film was floating on the water surface. A fourth pellicle film, which was formed from a CNT film having a mesh structure, was thereby obtained.

A fourth pellicle frame, which was the same size and material as the first pellicle frame, was readied. A third silicon frame was a tubular object. The third silicon frame had a through-hole, and the through-hole was formed along the thickness direction of the third silicon frame. The CNT film was rinsed with water, and the polyacrylic acid within the CNT film was removed, and drying was carried out. Next, the silicon substrate with the CNT film was immersed in water. In the water, the CNT film peeled-off from the silicon substrate and floated on the water surface. The CNT film was left in the water, and the silicon substrate was taken-out of the water. The CNT film floating on the water surface was skimmed off by the third silicon frame. The fourth pellicle was thereby obtained.

The fourth pellicle had the third pellicle frame, and the third pellicle film that was formed from a CNT film. The third pellicle film was supported by the third pellicle frame. The thickness of the third pellicle film was 50 nm or less. The size and material of the third pellicle frame were the same as the size and the material of the first pellicle frame.

[8] Evaluation

Evaluation of Film Breakage

The pellicle film of the irradiated pellicle was checked visually, and film breakage was evaluated in accordance with the standards described hereinafter. As Reference Example 1, similar evaluation was carried out also on the first pellicle before placement thereof on the stage 12. As Reference Example 2, similar evaluation was carried out also on the second pellicle before placement thereof on the stage 12. As Reference Example 3, similar evaluation was carried out also on the third pellicle before placement thereof on the stage 12. As Reference Example 4, similar evaluation was carried out also on the fourth pellicle before placement thereof on the stage 12. The results of evaluation are shown in Table 1.

A: no occurrence of film breakage of pellicle film
B: film breakage of pellicle film occurred

Measurement of Foreign Matter

The number of pieces of foreign matter adhered to the pellicle film of the processed pellicle was measured by the following method. As Reference Example 1, similar measurement was carried out also on the first pellicle before placement thereof on the stage 12. As Reference Example 2, similar measurement was carried out also on the second pellicle before placement thereof on the stage 12. As Reference Example 3, similar evaluation was carried out also on the third pellicle before placement thereof on the stage 12. As Reference Example 4, similar measurement was carried out also on the fourth pellicle before placement thereof on the stage 12. The results of measurement are shown in Table 1.

The number of pieces of foreign matter was measured by using an image in which a range of 142.70 mm $\times$ 110.25 mm, with one pixel being 3.69 $\mu$m $\times$ 3.69 $\mu$m, was captured at a magnification of 5X by using an optical microscope (Olympus MX series). The entire image was analyzed by calculation software that was accessory to the optical microscope, and the counted number, the sizes, and the types of the foreign matter were distinguished. Note that foreign matter of a size of from more than 5 $\mu$m to 10.5 $\mu$m could not be confirmed. The limit of the size of foreign matter that could be detected by the device was 1 $\mu$m.

"Size of the foreign matter" means the size measured by detecting foreign matter within an image range of X: 320 $\mu$m and Y: 740 $\mu$m, and, for each piece of the foreign matter, computing the ESD (equivalent spherical diameter).

Transmittance

By using EUV-RT (Reflection and Transmission), a wavelength of 13.5 nm was irradiated onto the pellicle film, and the current value was measured. In detail, the current value (incident light intensity I0) detected in a state in which the pellicle was not set, and the current value (transmitted light intensity I) detected in a state in which the pellicle film was set, were measured by using a photodiode. In the measuring of the current value (the transmitted light intensity I), the entire pellicle film surface was divided into 48 places, and the current value (the transmitted light intensity I) of each region was measured. The transmittance of each region was calculated by following formula (1), and the average value thereof was used as the transmittance. As Reference Example 1, similar measurement was carried out also for the first pellicle before placement thereof on the stage 12. As Reference Example 2, similar measurement was carried out also for the second pellicle before placement thereof on the stage 12. As Reference Example 3, similar evaluation was carried out also for the third pellicle before placement thereof on the stage 12. As Reference Example 4, similar measurement was carried out also for the fourth pellicle before placement thereof on the stage 12 in Example 4. The results of measurement are shown in Table 1.

[Formula 1]

$$Tr = I / I_0 \qquad (1)$$

[Table 1]

| | film type | absence / presence of gas supplying step | irradiating step | | | | | film breakage evaluation | measurement of foreign matter | | | transmittance (%) |
| | | | inert gas atmosphere | | VUV light | | | | number of pieces | | | |
| | | | oxygen concentration | nitrogen concentration | wavelength | cumulative amount | illuminance | | from 1$\mu$m to 5$\mu$m | from 6um to 10um | > 10.5um | |
| | | | vol% | vol% | nm | J/cm$^2$ | mW/cm$^2$ | | no. of pieces | no. of pieces | no. of pieces | |
| Ex. 1 | p-Si | yes | 0.6 | $\leqq$ 98 | 172 | 2 | 33 | A | 30 | 0 | 7 | 82.00 |
| Comp.Ex. 1 | p-Si | no | 21 | 79 | 172 | 2 | 33 | B | - | - | - | - |
| Ref.Ex. 1 | p-Si | no | - | - | - | - | - | A | 120 | 0 | 12 | 81.90 |
| Ex. 2 | MoSi | yes | <0.01 | 99.9 | 172 | 2 | 33 | A | 39 | 23 | 16 | 88.40 |
| Comp.Ex. 2 | MoSi | no | 21 | 79 | 172 | 2 | 33 | B | - | - | - | - |
| Ref.Ex. 2 | MoSi | no | - | - | - | - | - | A | 91 | 27 | 10 | 88.25 |
| Ex. 3 | MoSi | yes | <0.01 | 99.9 | 172 | 2 | 66 | A | 708 | 73 | 20 | 88.23 |
| Comp.Ex. 3 | MoSi | no | 21 | 79 | 172 | 2 | 66 | B | - | - | - | - |
| Ref.Ex. 3 | MoSi | no | - | - | - | - | - | A | 1543 | 80 | 52 | 88.22 |
| Ex. 4 | CNT | yes | <0.01 | >99.9 | 172 | 1 | 33 | A | 2158 | 2942 | 1732 | 93.70 |
| Ref.Ex. 4 | CNT | no | <0.01 | >99.9 | - | - | - | A | 3844 | 6114 | 4952 | 93.45 |

In Table 1, "from 1 $\mu$m to 5 $\mu$m" in the foreign matter measurement category means the number of pieces of foreign matter of a size of from 1 $\mu$m to 5 $\mu$m within a 1 $mm^2$ region of the pellicle film. The "$\leq$ 10.5 $\mu$m" in the foreign matter measurement category means the number of pieces of foreign matter of a size of 10.5 $\mu$m or larger within a 1 $mm^2$ region of the pellicle film. The " to " in the category foreign matter measurement means that the number of pieces of foreign matter could not be measured due to film breakage of the pellicle film. The " to " in the categories of gas supplying step and irradiating step means that the gas supplying step and the irradiating step were not carried out. The "$\leq$ 98" in the nitrogen concentration category means that the nitrogen concentration was 98 vol% or more.

In Comparative Example 1 through Comparative Example 3, the gas supplying step was not carried out. At the time of carrying out the irradiating step, the oxygen concentration within the irradiation chamber 10A was 21 vol%. As a result, the evaluation of film breakage in the Comparative Examples was "B".

From these results, it can be understood that the pellicle film producing methods of the Comparative Examples could not prevent the occurrence of breakage of the pellicle film.

In Example 1 through Example 4, the gas supplying step and the irradiating step were carried out simultaneously. At the time of carrying out the irradiating step, the oxygen concentration within the irradiation chamber 10A was 5 vol% or less (specifically, was 0.6 vol% in Example 1, and was 0.01 vol% in Example 2 through Example 4). As a result, the evaluation of film breakage in Example 1 through Example 4 was "A". Moreover, the number of pieces of foreign matter that was measured in Example 1 was lower than the number of pieces of foreign matter that was measured in Reference Example 1. The number of pieces of foreign matter that was measured in Example 2 was lower than the number of pieces of foreign matter that was measured in Reference Example 2. The number of pieces of foreign matter that was measured in Example 3 was lower than the number of pieces of foreign matter that was measured in Reference Example 3. The number of pieces of foreign matter that was measured in Example 4 was lower than the number of pieces of foreign matter that was measured in Reference Example 4.

From these results, it can be understood that the pellicle film producing methods of the Examples can prevent the occurrence of breakage of a pellicle film, and can remove foreign matter adhering to the pellicle film.

The disclosure of Japanese Patent Application No. 2022-140279 filed on September 2, 2022, and the disclosure of Japanese Patent Application No. 2023-047154 filed on March 23, 2023 are, in their entireties, incorporated by reference into the present specification.

All publications, patent applications, and technical standards mentioned in the present specification are incorporated by reference into the present specification to the same extent as if such individual publication, patent application, or technical standard was specifically and individually indicated to be incorporated by reference.

**Claims**

1. A foreign matter removing device comprising:

     a vacuum ultraviolet light generating section generating vacuum ultraviolet light;
     an irradiation container for irradiating the vacuum ultraviolet light onto a pellicle film; and
     a gas supplying section supplying inert gas to the irradiation container,
     wherein the irradiation container has an irradiation chamber at which are provided a gas supply port for supplying the inert gas and a gas discharge port for discharging the inert gas, and
     wherein the gas supplying section is connected to the gas supply port.

2. The foreign matter removing device of Claim 1, further comprising, at a border between the irradiation chamber and the vacuum ultraviolet light generating section, a transmitting portion that transmits the vacuum ultraviolet light.

3. The foreign matter removing device of Claim 1, further comprising a stage that is disposed within the irradiation chamber and is for placement of the pellicle film.

4. The foreign matter removing device of Claim 1, wherein the inert gas includes nitrogen gas.

5. The foreign matter removing device of Claim 1, wherein a cumulative amount of the vacuum ultraviolet light is from 0.1 $J/cm^2$ to 100 $J/cm^2$.

6. The foreign matter removing device of Claim 1, wherein illuminance of the vacuum ultraviolet light is from 5 $mW/cm^2$ to 100 $mW/cm^2$.

7. The foreign matter removing device of Claim 3, further comprising, at a border between the irradiation chamber and the vacuum ultraviolet light generating section, a transmitting portion that transmits the vacuum ultraviolet light, wherein the irradiation container further has a distance adjusting section that adjusts a distance between the transmitting portion and the stage.

8. The foreign matter removing device of Claim 1, wherein the gas discharge port is disposed at a position that is lower than a height positioned at a center of the irradiation chamber, in a height direction of the irradiation chamber.

9. The foreign matter removing device of Claim 8, wherein the gas supply port is disposed at a position that is higher than the height positioned at the center of the irradiation chamber, in the height direction of the irradiation chamber.

10. The foreign matter removing device of Claim 1, wherein:

    the irradiation chamber has two wall portions that face one another,
    the gas supply port is disposed at one of the two wall portions that face one another, and
    the gas discharge port is disposed at another of the two wall portions that face one another.

11. A pellicle producing device comprising the foreign matter removing device of any one of Claim 1 through Claim 10.

12. A pellicle film producing method comprising:

    supplying inert gas to an irradiation chamber; and
    irradiating vacuum ultraviolet light onto a pellicle film in an inert gas atmosphere within the irradiation chamber, wherein a concentration of oxygen gas in the inert gas atmosphere within the irradiation chamber is 5 vol% or less.

13. The pellicle film producing method of Claim 12, wherein the concentration of the oxygen gas within the irradiation chamber is 3 vol% or less.

14. The pellicle film producing method of Claim 12 or Claim 13, wherein the inert gas includes nitrogen gas.

15. The pellicle film producing method of Claim 12 or Claim 13, wherein a flow rate of the inert gas is from 10 L/minute to 1000 L/minute.

16. The pellicle film producing method of Claim 12 or Claim 13, wherein a cumulative amount of the vacuum ultraviolet light is from 0.1 $J/cm^2$ to 100.0 $J/cm^2$.

17. The pellicle film producing method of Claim 12 or Claim 13, wherein illuminance of the vacuum ultraviolet light is from 5 $mW/cm^2$ to 100 $mW/cm^2$.

18. The pellicle film producing method of Claim 12 or Claim 13, wherein an irradiation time of the vacuum ultraviolet light is from 1 second to 30 minutes.

19. The pellicle film producing method of Claim 12 or Claim 13, wherein:

    the irradiation chamber has, at a border of the irradiation chamber, a transmitting portion that transmits the vacuum ultraviolet light, and
    an irradiation distance between the transmitting portion and the pellicle film is from 0.3 mm to 2.0 mm.

20. The pellicle producing method of Claim 12 or Claim 13, wherein a film thickness of the pellicle film is 100 nm or less.

21. A pellicle comprising:

    a pellicle frame; and
    a pellicle film supported at the pellicle frame,
    wherein:

        the pellicle film has a film thickness of 100 nm or less,
        the pellicle film contains foreign matter of a size of from 1 $\mu$m to 5 $\mu$m, and
        a number of pieces of the foreign matter is 35 or fewer.

# FIG.1

# FIG.2

## EP 4 560 398 A1

| INTERNATIONAL SEARCH REPORT | International application No. |
|---|---|
| | **PCT/JP2023/030137** |

**A. CLASSIFICATION OF SUBJECT MATTER**

*G03F 1/62*(2012.01)i; *G03F 1/82*(2012.01)i; *G03F 7/20*(2006.01)i
FI: G03F1/62; G03F1/82; G03F7/20 503

According to International Patent Classification (IPC) or to both national classification and IPC

**B. FIELDS SEARCHED**

Minimum documentation searched (classification system followed by classification symbols)

G03F1/62; G03F1/82; G03F7/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | US 2010/0190095 A1 (TAIWAN SEMICONDUCTOR MANUFACTURING CO., LTD.) 29 July 2010 (2010-07-29)<br>paragraphs [0001]-[0043], fig. 1-5 | 1-21 |
| X | WO 2016/136343 A1 (MITSUI CHEMICALS, INC.) 01 September 2016 (2016-09-01)<br>claims, paragraphs [0001]-[0008], [0033]-[0037] | 21 |
| A | JP 5-323584 A (SHIN ETSU CHEM CO LTD) 07 December 1993 (1993-12-07)<br>entire text, all drawings | 1-21 |
| A | JP 2022-507168 A (ASML NETHERLANDS B.V.) 18 January 2022 (2022-01-18)<br>entire text, all drawings | 1-21 |
| A | CN 101989037 A (SEMICONDUCTOR MANUFACTURING INTERNATIONAL (SHANGHAI) CORPORATION) 23 March 2011 (2011-03-23)<br>entire text, all drawings | 1-21 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **11 September 2023** | **26 September 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2023/030137**

| Patent document cited in search report | | | Publication date (day/month/year) | Patent family member(s) | | | Publication date (day/month/year) |
|---|---|---|---|---|---|---|---|
| US | 2010/0190095 | A1 | 29 July 2010 | US | 2012/0308922 | A1 | |
| | | | | CN | 101788770 | A | |
| | | | | TW | 201028792 | A | |
| WO | 2016/136343 | A1 | 01 September 2016 | US | 2017/0285461 | A1 | |
| | | | | claims, paragraphs [0002]-[0008], [0069]-[0073] | | | |
| | | | | EP | 3264175 | A1 | |
| | | | | KR | 10-2017-0070146 | A | |
| | | | | CN | 107003602 | A | |
| | | | | SG | 11201705304P | A | |
| | | | | TW | 201631199 | A | |
| JP | 5-323584 | A | 07 December 1993 | US | 5327808 | A | |
| | | | | entire text, all drawings | | | |
| JP | 2022-507168 | A | 18 January 2022 | US | 2022/0008963 | A1 | |
| | | | | entire text, all drawings | | | |
| | | | | WO | 2020/109152 | A1 | |
| | | | | NL | 2024289 | A | |
| | | | | CN | 113168088 | A | |
| | | | | KR | 10-2021-0093263 | A | |
| | | | | TW | 202040262 | A | |
| CN | 101989037 | A | 23 March 2011 | (Family: none) | | | |

Form PCT/ISA/210 (patent family annex) (January 2015)

24

**EP 4 560 398 A1**

**Patent documents cited in the description**

- WO 2021073799 A
- WO 2020109152 A
- WO 2015182483 A
- WO 2015182482 A
- JP 2021157058 A
- JP 2020166063 A
- JP 2020160345 A
- WO 2019240166 A
- JP 2019174628 A
- JP 2022140279 A
- JP 2023047154 A